# EUROPEAN PATENT SPECIFICATION

(11) **EP 2 162 899 B1**
(45) Date of publication and mention of the grant of the patent: **21.01.2015**
(21) Application number: 08761019.2
(22) Date of filing: 13.06.2008
(51) Int. Cl.: H01J 37/34, C23C 14/35

(54) **MULTITARGET SPUTTER SOURCE AND METHOD FOR THE DEPOSITION OF MULTI-LAYERS**
MEHRTARGET-SPUTTER-QUELLE UND VERFAHREN ZUR ABSCHEIDUNG VON MEHRFACHSCHICHTEN
SOURCE DE PULVERISATION MULTICIBLE ET PROCEDE DE DEPOT MULTICOUCHE

(30) Priority: 15.06.2007 US 944118 P
(43) Date of publication of application: 17.03.2010
(73) Proprietor: Oerlikon Advanced Technologies AG, 9496 Balzers (LI)
(72) Inventor: ROHRMANN, Hartmut, 69198 Schriesheim (DE)
(74) Representative: Troesch Scheidegger Werner AG
(86) International application number: PCT/EP2008/057500
(87) International publication number: WO 2008/152135

(56) References cited:
- EP-A- 0 163 445
- EP-A- 0 945 524
- DE-A1- 3 908 252
- US-A- 4 761 218
- US-B1- 6 488 822

## Description

### Field of the Invention

This invention relates to multitarget sputter sources for materials with high saturation magnetization and a method for the deposition of multilayers and further to a method for Co-Sputtering of alloys incorporating materials of high saturation magnetization.

### Background of the invention

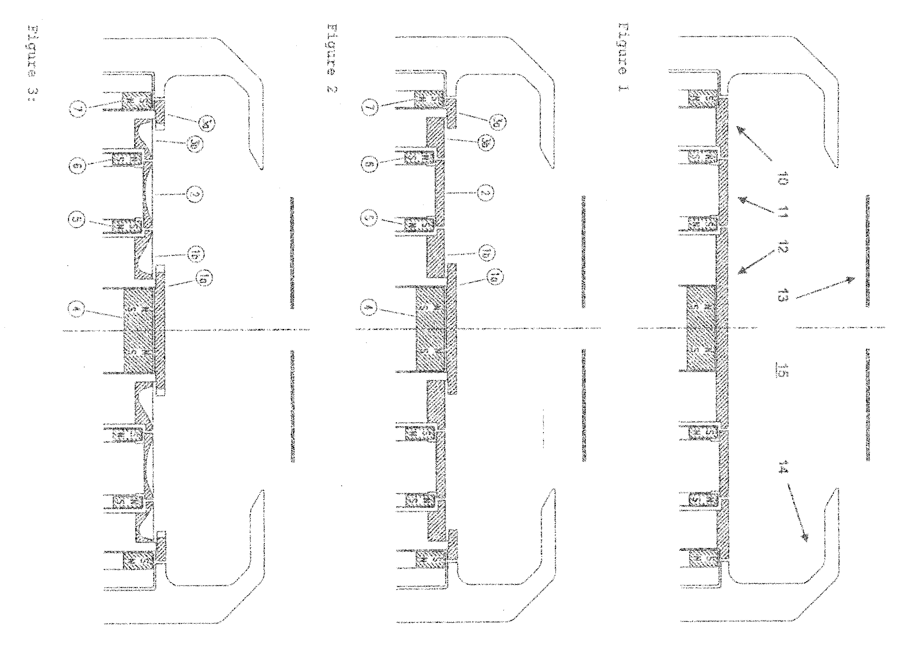

Multi-target sputter sources are well proven for the deposition of multi-layers and special alloys in hard disk media. EP 0 162 643 shows the basic principle of such a sputter source comprising concentric annular targets with independent magnetic poles and independent plasma power sources. Figure 1 of this present application shows the Oerlikon/Unaxis Triatron sputter source 15 with three concentric targets 10, 11, 12 with respective magnetic means (permanent magnets arranged beneath the target). Usually a separate power supply for each target, typically DC power supply, is being used. In the Triatron design there is no anode arranged between the concentric targets 10-12 and the spacing between the targets is reduced to the spacing required to avoid parasitic plasma between the targets (dark space). A shielding 14 is provided to collect material not reaching the substrate 13. The substrate is arranged in a plane, distant but essentially in parallel to the plane of the unused sputter surfaces. Here the substrate is shown with a center, hole, as it is e. g. common for hard disk substrates. The diameter of such substrates is usually varying from 20 to 100 mm. In the arrangement shown the outer diameter of annular target 10 is 165mm, of target 11 121 mm, target, 12 72mm. The expert will vary the diameter according to the needs of the films / layers to be sputtered, including the teachings described in US 6,579,424.

In a typical application the outermost target 10 and the innermost target 12 consist of cobalt Co, target 11 of Palladium Pd. The thickness of the target varies from 2 mm to 8 mm. The target-substrate distance is typically 50 mm.

This lay-out works well for nonmagnetic targets and for targets of low magnetization, but has very limited performance for high magnetization target materials which are frequently used in the production of magnetic hard disks. The problem of sputtering high magnetization materials is that the magnetic field produced by an array of magnets behind the target does not penetrate the magnetic target sufficiently. Since a magnetic field projecting above the surface of a target is a prerequesite for the occurrence of the magnetron sputter effect, it is clear that high magnetization targets cannot easily be applied in standard magnetron cathodes, since the width of the eroded area tends to be too small (pinging effect).

Several possibilities to sputter high magnetization material are known in the art: One comprises to choose stronger magnets to magnetically (over-) saturate the target and/or to choose thin targets of a few Millimeters of material.

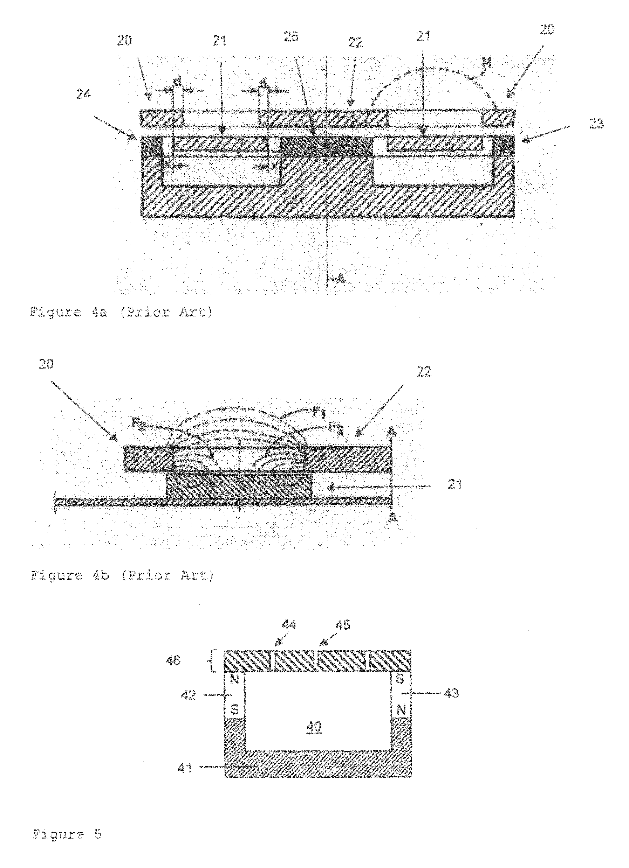

A further known technology to sputter high magnetization material is a target arrangement 40 with trenches and bores, shown in fig. 5. A target 46 of high magnetization material is placed on magnets 42, 43. On the backside a yoke 41 may be used. The target 46 will guide most, if not all of the magnetic flux lines. By applying a trench 44 or a bore 45 the magnetic flux lines are forced to bridge a gap. In such areas a plasma can ignite and a magentron sputtering effect can occur. Typically, the trenches will have a width of 0.5 to 1.5 mm. A target thickness of 20 mm has been used successfully.

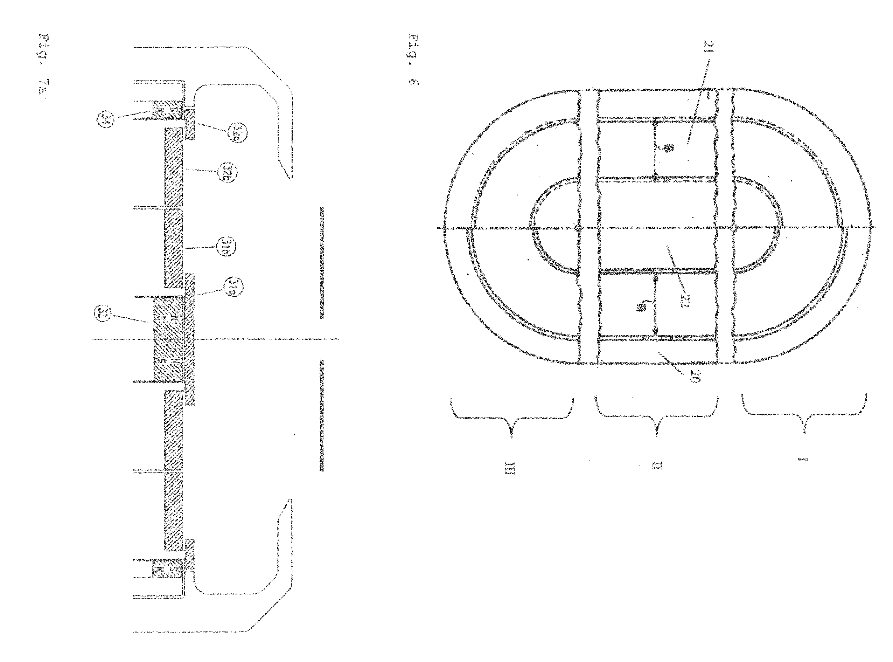

Another known techology for sputtering high magnetization materials is the so called roof target arrangement as shown in US 4,572,776 or US 4,601,806 respectively. Further reference is made to DE 39 08 252 A1. Figures 4a & b illustrate the principle. In this arrangement the target material is divided into at least two parts, with one part arranged partially in a plane essentially parallel to and above the surface of the other part. Fig. 4a illustrates this with the cross-section of a three-part-design; target 21 being arranged in a first, "lower" plane and targets 20, 22 arranged in a second, "upper" plane. Figure 6 illustrates a topview on said roof target arrangement; it is clear, that such a design is applicable to an elongated target configuration, comprising sections I, II and III as well as to a circular configuration composed from sections I and III only. In a basic arrangement the middle part 22 could be omitted with the target part 21 being then a continuous plate. However, since the transitions between the target parts are also the active, plasma-exposed ones, omitting such further target part results in a loss of active area.

Fig. 4a illustrates a cross section through a target arrangement with a central axis A.

Fig. 4b shows with more detail the magnetic properties for one half of said target arrangement. In this arrangement the magnetic field is produced by permanent magnets 23, 24, 25. For material with high magnetization saturation an undivided target will act as a shunt for the magnet field lines, i. e. figuratively there will be not sufficient field lines available above the target surface in order to allow the formation of a tunnel-like magnetic field which is again the prerequisite for the closed plasma loop of the magnetron effect. By dividing the target 20, 21, 22 the magnetic field lines generated by magnets 23, 24, 25 are forced to bridge the gaps as indicated in fig. 4b, so that in the regions marked F₂ two tunnel-like magnetic fields occur. Here the magnetic field extends from the upper target part 20, 22 to the lower target part 21 and the magnetic target material itself is used as a magnetic flux guide resulting in sufficiently strong magnetic fields above the target arrangement. With the help of this magnetic field the erosion area is widened compared to a conventional target arrangement with a flat target and permanent magnets arranged behind the target. Additionally, the target thickness of the high magnetization material is not limited by the available strength of the permanent magnets. Further, a certain focusing effect can be observed, i. e. the sputtered material has a preferred direction due to the step-like design of the sputter region.

It has to be noted, that the arrangement shown in US 4,572,776 or US 4,601,806 respectively use a single power source and the same material for all target parts.

Materials with high magnetization are materials with a saturation magnetization (4π Ms) of more than 8000Gauss (in cgs-units).

Disadvantages of existing Triatron Design:
- For materials with high magnetization only very thin targets can be used and the target utilization is low due to the fact that the target is eroded only on a small area (pinging effect).
- RF sputtering of the high magnetization material is in principle possible with the existing Triatron design. However, the maximum possible sputter rate is quite low and there is a large power directed to the substrate causing excessive heating of the substrate and deterioration of the film properties due to the fact that with RF sputtering the volume of the sputtering plasma extends towards the substrate.

Disadvantage of the roof target technology:
- Only a single target material arrangement is known in the prior art, which does not allow to produce multi layers or alloying of materials in the deposited film by co-sputtering.
- Furthermore, with a target arrangement as known in the art (Fig. 4a, b) there are two areas on the target with respective plasmas and it is very difficult to control the relative sputter powers in the two respective areas.

Disadvantage of the trench & bore technology:
- Again, only a single material can be used in such an arrangement and does provide for the possibility to produce multi layers or alloying of materials in the deposited film by co-sputtering. The fabrication process of such targets is elaborate and expensive, especially if many bores and/or trenches are necessary.

### Summary of the Invention

The solution according to the invention is directed to combining the advantages from the technologies described above and at the same time directed to avoiding the individual, known disadvantages of said sources. Moreover it has been found that by carefully choosing process parameters and material's choice further advantages can be realized.

A sputter source according to the present invention is defined in appended claim 1.

A method of sputtering according to the invention is defined in appended claim 7.

A target arrangement as described herein refers to a target surface from which sputter material is drawn during a sputtering operation as known in the art, where selectively a sputtering plasma can be ignited during operation. The addressed target surface needs not to form an uninterrupted plane, but may comprise steps, trenches, bores or other gaps.

A general embodiment of the invention can be described as a sputter coating apparatus with at least two target arrangements (1a/b, 2, 3a/b); a first target arrangement and a second target arrangement completely surrounding said first target arrangement; means for generating a magnetic field at least partially above each of said target arrangements and individually controllable power sources allocated to each of said target arrangements. Both of said target arrangements comprise a first (e. g. upper 1a, 3a) and a second (e. g. lower Ib, 3b) part, said first part being arranged in a plane spaced apart from and essentially parallel to the plane of said second part and said first part protruding partially over said second part. In a preferred embodiment of said general embodiment at least one of said target arrangement comprises trenches, bores or other gaps.

In a further embodiment a third target arrangement completely surrounding said second and first target arrangement is provided for.

In further preferred embodiments said targets may be construed to feature an annular, concentric design or an extended design as shown in fig. 6. Materials of said target arrangements may vary with materials of high magnetization saturation being arranged preferably in target arrangements with lower/upper part design.

Such sputter coating apparatus may be used for methods for coating substrates with films of materials of high magnetization saturation; either alone or in combination or alternation with other materials in order to form alloyed films or alternating films (layer systems) on said substrates. With said inventive apparatus being able to provide different materials in one source there is no need to transport a substrate between different process stations being individually equipped with sources dedicated for one material or material alloy.

### Brief Description of the Drawings

All of the following figures are schematic and illustrative in nature.
Fig. 1 shows a cross-section of a conventional multi-target source arrangement for magnetron sputtering.
Fig. 2 shows a cross-section of a multi-target source arrangement for magnetron sputtering according to an exemplary embodiment of the invention.
Fig. 3 shows a cross-section as in Fig. 2, wherein the sputtering targets have been eroded through sputtering to near the end of their lives.
Fig. 4a shows a conventional roof-target sputtering arrangement.
Fig. 4b illustrates magnetic field lines associated with the operation of the roof-target sputtering system illustrated in Fig. 4a.
Fig. 5 illustrates a sputter-target arrangement including bores and trenches in the sputter targets
Fig. 6 is a plan view of a multi-source sputter target arrangement in a 'racetrack' configuration, wherein the sputter targets have been elongated linearly relative to an axis of symmetry.
Fig. 7a shows a cross-section of a multi-target source arrangement for magnetron sputtering according to a further exemplary embodiment of the invention.
Fig. 7b shows a cross-section as in Fig. 7a, wherein the sputtering targets have been eroded through sputtering to near the end of their lives.
Fig. 7c shows a cross-section of a multi-target source arrangement for magnetron sputtering according to yet a further exemplary embodiment of the invention.

### Detailed Description of Preferred Embodiments

The solution will now be described, with the aid of the figures. Customary accessories like vacuum pumps, electric connectors, cooling systems, gas inlets and alike have been omitted to facilitate understanding. It is understood that a man skilled in the art will add such equipment based on his knowledge without further inventive effort. Such an inventive sputter source will be assembled in a vacuum vessel with means to provide for a sufficient vacuum and supply lines for a working gas for the plasma process such as Argon or Krypton under conditions to be adjusted to the respective pressure regime and flow rate. Commonly used pressure ranges from 6 x 10⁻⁴ to 6 x 10⁻² hPa (mbar).

In figure 2 the inner target arrangement 1a/1b and the outer target arrangement 3a/3b are construed to comprise materials with high magnetization. These two target arrangements are divided into an upper (1a and 3a) and a lower part (1b and 3b) in a step-like arrangement. Upper and lower parts do not touch, the vertical distance between them is chosen as a compromise between the needs of guiding the magnetic field and avoiding parasitic plasma igniting in the gap. This distance will normally be between 0.5 and 6mm, preferably between 1-1.5mm, depending on the electric and magnetic properties. The middle target arrangement 2 (ringshaped) is shown as comprising nonmagnetic or low-magnetization material. The arrangement of permanent magnets consists of four concentric rings 4-7 with a magnetic polarity which is alternating from one ring to the next ring. The magnetron field for the inner target 1a/1b is produced by the permanent magnet rings 4 and 5. The magnetron field for the middle target 2 is produced by the permanent magnet rings 5 and 6. The magnetron field for the outer target 3a/3b is produced by the permanent magnet rings 6 and 7. The strength of said magnets is chosen according to the specific requirements of the sputtering process and takes into account the material to be sputtered.

This arrangement utilizes the roof target effect for the two pairs of targets 1a/1b and 3a/3b, respectively. Due to this effect high magnetization materials can be used for the targets 1a/1b and 3a/3b and the eroded area on these targets has a large width as indicated in the graph. Moreover the a. m. focus effect can be utilized to imrobe the deposition homogeneity in the substrate. Due to the fact that the sputter voltage can be applied independently to the target arrangements 1a/1b and 3a/3b, respectively, the sputter power on these two areas can easily be controlled independently and the areas can be sputtered independently.

The target 2 may also be used as an independent sputter source and by applying a power to this sputter target 2 the advantages of the Triatron design can be utilized for high magnetization materials in combination with non magnetic / low magnetization materials. There are several modes of operation for such a source according to fig. 2, 3:
- In one suggested sputter mode the targets 1a/1b and 3a/3b are made of the same high magnetization material and are sputtered simultaneously to form a first film while the target 2 is not sputtered. A second film is then formed by sputtering target 2 while the targets 1a/1b and 3a/3b are not sputtered. A multi-layer structure of thin films can be formed by repeating this sputter sequence. The sputter powers on target 1a/1b and target 3a/3b are typically tuned to reach an optimal uniformity of the sputtered high magnetization material on the substrate.
- In a variation of this first sputter mode, the sputter power on target 2 is reduced to a very small level (typically in the range 5-20W) while sputtering the targets 1a/1b and 3a/3b with higher power and, in the opposite logic, sputtering the targets 1a/1b and 3a/3b with a very small power (5-20W each) while sputtering the target 2 with higher power. This mode is used to prevent deposition of the high magnetisation material from target 1a/1b and 3a/3b on target 2, and, in the same way, deposition of the non magnetic / low magnetization material from target 2 on target 1a/1b and 3a/3b during sputtering the other material, respectively. With this sputter mode, the cross contamination of the different materials is reduced.
- In another suggested sputter mode all targets are sputtered simultaneously to form an alloyed film on the substrate. The composition of the alloyed film is adjusted by adjusting the sputter powers on the targets 1a/1b, 2 and 3a/3b, respectively.
- It is possible to operate the targets 1a/1b & 3a/3b with a DC power supplies (independently) and target 2 with DC or RF power supply. Other combinations of power supplies may be used. The power ratios for the supplies will be adjusted according to the needs of the sputtering process.
- In case reactive sputtering should be necessary, the inventive sputter apparatus may be complemented by respective gas inlets in order to allow reactive sputtering.
- Other sputter modes with sequences of alloying and deposition of thin film stacks with varying thicknesses can be realized straightforwardly.

The described inventive sputtering apparatus allows sputtering of a choice of materials nowadays used in modern Hard Disk layer design:

| Target 3a, 3b | Target 2 | Target 1a, 1b |
|---|---|---|
| Fe | Pt | Fe |
| CoCrPt(B) | Ru | CoCrPt(B) |
| CoCrPt(B) | SiO₂ | CoCrPt(B) |
| CoFe | X | CoFe |
| CoZr | X | CoZr |
| FeTb | X | FeTb |
| FeCoTbGd | X | FeCoTbGd |

| | | |
|---|---|---|
| X = Pt, Pd, Ru or alloys thereof. | | |

The examples given are exemplary and not exhaustive.

It is further possible to equip all three target arrangements with targets comprising the same materials, but different shares (concentrations). Preferably expensive materials like Pt, Pd, Ru will be used for target 2.

For hard disk applications the sputter source preferably has circular shape with a concentric arrangement of targets and permanent magnets. However, a linearly extended sputter source as described for example in figure 6 is also possible with the current invention.

With a source and methods of operation according to the invention it is possible to create layer systems for soft magnetic underlayers in Hard Disks, e. g. FeCo, FeCoB or CoZrX (X = Ta, Nb). The subsequent use a further source according to the invention equipped with another set of target materials will allow to create CoCrPt + SiO₂ layers by the a. m. co-sputtering method.

Even the so called L10 phase can be realised based on a layer system Fe(Co) - Pt-Fe(Co) - Pt ... with a sputter coating apparatus according to the invention.

Figure 3 shows said inventive embodiment as discussed for fig. 2 with eroded target parts.

Figure 7a shows an embodiment with a step-like target arrangement 32a/32b and 31a/31b plus an arrangement with a central trench between 32b and 31 b. The magnetic flux can be provided by two sets of magnets 33, 34. The high magnetization material of target parts 31 a/b, 32 a/b will guide the magnetic flus respctively. The individual power distribution to said target arrangements allows the control of the sputter areas between 32a & b, 32b & 31 b, 31 b & 31 a. Again, this layout may be combined with further (concentric) target arrangements exhibiting roof-target technology / bore-trench technology or standard sputtering.

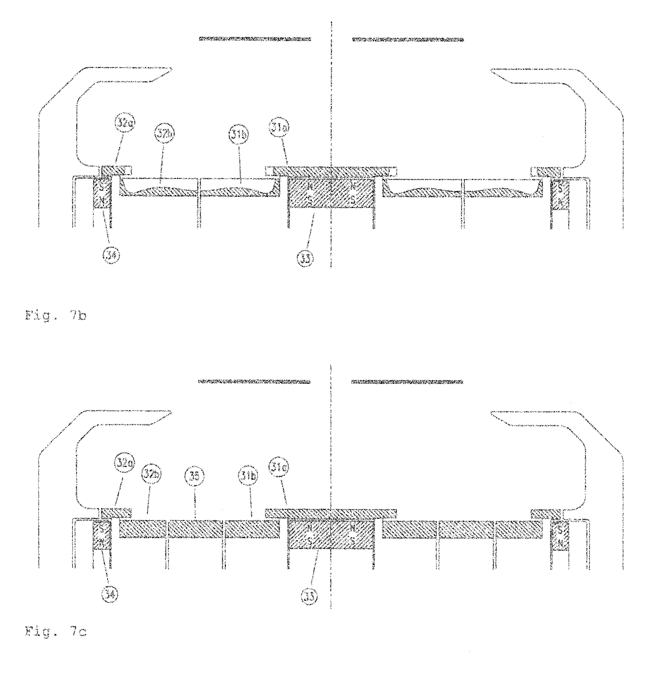

Figure 7b shows the embodiment of fig. 7a with eroded target parts.

Figure 7c exhibits another variant of fig. 7a with a further trench, creating an additional target arrangement. Again, target part 35 with individual power attribution will allow the control of the plasma regions.

While the invention has been described with respect to preferred embodiments, it will be understood that the invention is not to be limited thereby. Numerous additional embodiments and features will be readily apparent to the person having ordinary skill in the art based on reading the present disclosure, which fall within the scope of the present invention as set forth in the appended claims.

## Claims

1. A sputter source comprising:
an inner target arrangement (1 a, 1 b; 31 a, 31 b) and an outer target arrangement (3a, 3b; 32a, 32b), said outer target arrangement (3a, 3b; 32a, 32b) being disposed around said inner target arrangement (1a, 1b; 31a, 31b) when viewed from above, each of said inner (1a, 1b; 31a, 31b) and said outer (3a, 3b; 32a, 32b) target arrangements comprising a respective upper part (1a, 3a; 31a, 32a) and a respective lower part (1b, 3b; 31b, 32b), each said respective upper part (1a, 3a; 31a, 32a) being arranged in a plane spaced apart from and essentially parallel to the plane of the said respective lower part (1b, 3b; 31b, 32b), each said respective upper part (1a, 3a; 31a, 32a) protruding partially over the said respective lower part (1b, 3b; 31b, 32b); and
means for generating magnetic fields, said magnetic-field generating means being operable to separately generate first and second individually-controllable magnetic fields, respectively, at least partially above said inner (1 a, 1 b; 31 a, 31 b) and outer (3a, 3b; 32a, 32b) target arrangements.

2. The sputter source of claim 1, said magnetic-field generating means comprising separate power sources allocated to generate said individually-controllable magnetic fields.

3. The sputter source of one of the preceding claims, further comprising a middle target arrangement (2) disposed between said inner target arrangement (1a, 1b) and said outer target arrangement (3a, 3b) when viewed from above.

4. The sputter source of one of the preceding claims, said magnetic-field generating means being operable to separately generate a third individually-controllable magnetic field at least partially above said middle target arrangement.

5. The sputter source of one of the preceding claims, said inner (1a, 1 b; 31a, 31 b) and outer (3a, 3b; 32a, 32b) target arrangements each comprising respective upper parts (1a, 3a; 31 a, 32a) arranged in a common upper plane, said respective lower parts (1b, 3b; 31 b, 32b) being arranged in a common lower plane, wherein said upper plane is spaced apart from and essentially parallel to said lower plane.

6. The sputter source of one of the preceding claims, one of said inner and outer target arrangements comprising a material exhibiting high magnetization saturation and the other said target arrangement comprising a material exhibiting low magnetization saturation.

7. A method of sputtering comprising:
- providing a sputter source comprising an inner target arrangement (1 a, 1 b; 31 a, 31 b) and an outer target arrangement (3a, 3b; 32a, 32b), said outer target arrangement (3a, 3b; 32a, 32b) being disposed around said inner target arrangement (1a, 1b; 31 a, 31 b) when viewed from above, each of said inner (1a, 1b; 31 a, 31 b) and said outer (3a, 3b; 32a, 32b) target arrangements comprising a respective upper part (1a, 3a; 31 a, 32a) and a respective lower part (1b, 3b; 31 b, 32b), each said respective upper part (1a, 3a; 31 a, 32a) being arranged in a plane spaced apart from and essentially parallel to the plane of the said respective lower part (1b, 3b; 31 b, 32b), each said respective upper part (1a, 3a; 31 a, 32a) protruding partially over the said respective lower part (1 b, 3b; 31 b, 32b);
- providing a substrate arranged above and spaced from said target arrangements;
- generating a first magnetic field at least partially above said an inner target arrangement (1a, 1b; 31 a, 31 b) to thereby sputter material from said an inner target arrangement (1a, 1b; 31 a, 31 b) onto said substrate; and
- generating a second magnetic field at least partially above said outer target arrangement (3a, 3b; 32a, 32b) to thereby sputter material from said outer target arrangement (3a, 3b; 32a, 32b) onto said substrate;
wherein said first magnetic field is generated and controlled independently of said second magnetic field.

8. The method of claim 7, each of said first and second magnetic fields being generated from its own independent power source.

9. The method of claim 7 or claim 8, said sputter source further comprising a middle target arrangement (2) disposed between said inner target arrangement (1a, 1b) and said outer target arrangement (3a, 3b) when viewed from above, the method further comprising generating a third magnetic field at least partially above said middle target arrangement to thereby sputter material from said middle target arrangement onto said substrate, wherein said third magnetic field is generated and controlled independently of each of said first and second magnetic fields.

10. The method of one of claims 7 to 9, comprising co-sputtering material from each of said inner (1a, 1b; 31 a, 31 b) and outer (3a, 3b; 32a, 32b) target arrangements onto said substrate to produce an alloy layer comprising material from each of said target arrangements.

11. The method of claim 10, comprising generating said first and second magnetic fields simultaneously to achieve said co-sputtering.

12. The method of one of claims 7 to 9, comprising sputtering material from one of said inner (1a, 1b; 31 a, 31 b) and outer (3a, 3b; 32a, 32b) target arrangements onto said substrate and thereafter sputtering material from the other of said inner (1 a, 1 b; 31 a, 31 b) and outer (3a, 3b; 32a, 32b) target arrangements onto said substrate, thereby providing a plurality of sputtered layers on said substrate comprising discrete layers of material sputtered alternately from said inner and outer target arrangements.

13. The method of claim 12, comprising alternately generating said first and second magnetic fields individually to achieve alternate sputtering of material from said inner (1 a, 1 b; 31 a, 31 b) and outer (3a, 3b; 32a, 32b) target arrangements, respectively, to provide said plurality of sputtered layers.

14. The method of claim 12, comprising:
- first generating said first magnetic field at a low level and simultaneously generating said second magnetic field at a level effective to sputter material from said second target arrangement onto said substrate;
- thereafter generating said second magnetic field at a low level and simultaneously generating said first magnetic field at a level effective to sputter material from said inner target arrangement onto said substrate;
wherein said low-level magnetic fields are effective to inhibit cross-contamination of material between the respective inner and outer target arrangements.

15. Method of manufacturing a sputter-coated substrate comprising sputtering according to the method of any of claims 7-14.

## Patentansprüche

1. Sputter-Quelle, welche umfasst:
eine Anordnung (1a, 1b; 31a, 31b) eines inneren Ziels und eine Anordnung (3a, 3b; 32a, 32b) eines äusseren Ziels, wobei die Anordnung (3a, 3b; 32a, 32b) eines äusseren Ziels, von oberhalb betrachtet, um die Anordnung (1a, 1b; 31a, 31b) eines inneren Ziels angeordnet ist, wobei sowohl die Anordnung (1a, 1b; 31a, 31b) eines inneren Ziels als auch die Anordnung (3a, 3b; 32a, 32b) eines äusseren Ziels einen jeweiligen oberen Abschnitt (1a, 3a; 31a, 32a) und einen jeweiligen unteren Abschnitt (1b, 3b; 31b, 32b) umfassen, wobei der jeweilige obere Abschnitt (1a, 3a; 31a, 32a) in einer Ebene angeordnet ist, welche von der Ebene von dem jeweiligen unteren Abschnitt (1b, 3b; 31b, 32b) beabstandet ist und hierzu im Wesentlichen parallel verläuft, wobei der jeweilige obere Abschnitt (1a, 3a; 31a, 32a) teilweise über dem jeweiligen unteren Abschnitt (1b, 3b; 31b, 32b) vorragt; und
ein Element zum Erzeugen von Magnetfeldern, wobei das Magnetfeld-Erzeugungselement dazu ausgebildet ist, wenigstens teilweise oberhalb der Anordnung (1a, 1b; 31a, 31b) eines inneren Ziels und der Anordnung (3a, 3b; 32a, 32b) eines äusseren Ziels separat jeweils ein erstes und zweites individuell steuerbares Magnetfeld zu erzeugen.

2. Sputter-Quelle nach Anspruch 1, wobei das Magnetfeld-Erzeugungselement separate Leistungsquellen umfasst, welche dazu ausgebildet sind, die individuell steuerbaren Magnetfelder zu erzeugen.

3. Sputter-Quelle nach einem der vorhergehenden Ansprüche, ferner umfassend eine Anordnung (2) eines mittleren Ziels, welche, von oberhalb betrachtet, zwischen der Anordnung (1a, 1b) eines inneren Ziels und der Anordnung (3a, 3b) eines äusseren Ziels angeordnet ist.

4. Sputter-Quelle nach einem der vorhergehenden Ansprüche, wobei das Magnetfeld-Erzeugungselement dazu ausgebildet ist, wenigstens teilweise oberhalb der Anordnung eines mittleren Ziels ein drittes individuell steuerbares Magnetfeld separat zu erzeugen.

5. Sputter-Quelle nach einem der vorhergehenden Ansprüche, wobei die Anordnung (1a, 1b; 31a, 31b) eines inneren Ziels und die Anordnung (3a, 3b; 32a, 32b) eines äusseren Ziels jeweils jeweilige obere Abschnitte (1a, 3a; 31a, 32a), welche in einer gemeinsamen oberen Ebene angeordnet sind, und jeweilige untere Abschnitte (1b, 3b; 31b, 32b), welche in einer gemeinsamen unteren Ebene angeordnet sind, umfassen, wobei die obere Ebene von der unteren Ebene beabstandet ist und hierzu im Wesentlichen parallel verläuft.

6. Sputter-Quelle nach einem der vorhergehenden Ansprüche, wobei die Anordnung eines inneren Ziels oder die Anordnung eines äusseren Ziels ein Material umfasst, welches eine hohe Magnetsättigung darlegt, und die weitere Anordnung eines Ziels hiervon ein Material umfasst, welches eine niedrige Magnetsättigung darlegt.

7. Sputter-Verfahren, welches umfasst:
- Bereitstellen von einer Sputter-Quelle, welche eine Anordnung (1a, 1b; 31a, 31b) eines inneren Ziels und eine Anordnung (3a, 3b; 32a, 32b) eines äusseren Ziels umfasst, wobei die Anordnung (3a, 3b; 32a, 32b) eines äusseren Ziels, von oberhalb betrachtet, um die Anordnung (1a, 1b; 31a, 31b) eines inneren Ziels angeordnet ist, wobei sowohl die Anordnung (1a, 1b; 31a, 31b) eines inneren Ziels als auch die Anordnung (3a, 3b; 32a, 32b) eines äusseren Ziels einen jeweiligen oberen Abschnitt (1a, 3a; 31a, 32a) und einen jeweiligen unteren Abschnitt (1b, 3b; 31b, 32b) umfassen, wobei der jeweilige obere Abschnitt (1a, 3a; 31a, 32a) in einer Ebene angeordnet ist, welche von der Ebene von dem jeweiligen unteren Abschnitt (1b, 3b; 31b, 32b) beabstandet ist und hierzu im Wesentlichen parallel verläuft, wobei der jeweilige obere Abschnitt (1a, 3a; 31a, 32a) teilweise über dem jeweiligen unteren Abschnitt (1b, 3b; 31b, 32b) vorragt;
- Bereitstellen eines Substrats, welches oberhalb der Anordnungen eines Ziels angeordnet ist und hiervon beabstandet ist,
- Erzeugen eines ersten Magnetfeldes wenigstens teilweise oberhalb der Anordnung (1a, 1b; 31a, 31b) eines inneren Ziels, um hierdurch Material von der Anordnung (1a, 1b; 31a, 31b) eines inneren Ziels auf das Substrat zu sputtern, und
- Erzeugen eines zweiten Magnetfeldes wenigstens teilweise oberhalb der Anordnung (3a, 3b; 32a, 32b) eines äusseren Ziels, um hierdurch Material von der Anordnung (3a, 3b; 32a, 32b) eines äusseren Ziels auf das Substrat zu sputtern,
wobei das erste Magnetfeld unabhängig vom zweiten Magnetfeld erzeugt und gesteuert wird.

8. Verfahren nach Anspruch 7, bei welchem sowohl das erste als auch das zweite Magnetfeld durch eine eigene unabhängige Leistungsquelle erzeugt werden.

9. Verfahren nach Anspruch 7 oder 8, bei welchem die Sputter-Quelle ferner eine Anordnung (2) eines mittleren Ziels umfasst, welche, von oberhalb betrachtet, zwischen der Anordnung (1a, 1b) eines inneren Ziels und der Anordnung (3a, 3b) eines äusseren Ziels angeordnet ist, wobei das Verfahren ferner ein Erzeugen von einem dritten Magnetfeld wenigstens teilweise oberhalb von der Anordnung eines mittleren Ziels umfasst, um hierdurch Material von der Anordnung eines mittleren Ziels auf das Substrat zu sputtern, wobei das dritte Magnetfeld unabhängig von sowohl dem ersten als auch dem zweiten Magnetfeld erzeugt und gesteuert wird.

10. Verfahren nach einem der Ansprüche 7 bis 9, umfassend ein nebengeordnetes Sputtern von Material von sowohl der Anordnung (1a, 1b; 31a, 31b) eines inneren Ziels als auch der Anordnung (3a, 3b; 32a, 32b) eines äusseren Ziels auf das Substrat, um eine Legierungsschicht zu erzeugen, welche Material von jeder der Ziel-Anordnungen umfasst.

11. Verfahren nach Anspruch 10, umfassend ein gleichzeitiges Erzeugen des ersten und zweiten Magnetfeldes, um das nebengeordnete Sputtern zu erzielen.

12. Verfahren nach einem der Ansprüche 7 bis 9, umfassend ein Sputtern von Material von der Anordnung (1a, 1b; 31a, 31b) eines inneren Ziels oder der Anordnung (3a, 3b; 32a, 32b) eines äusseren Ziels auf das Substrat, und ein nachfolgendes Sputtern von Material von der weiteren Anordnung von der Anordnung (1a, 1b; 31a, 31b) eines inneren Ziels und der Anordnung (3a, 3b; 32a, 32b) eines äusseren Ziels auf das Substrat, um hierdurch auf dem Substrat eine Mehrzahl von Sputterschichten bereitzustellen, umfassend diskrete Materialschichten, welche abwechselnd von der Anordnung eines inneren Ziels und der Anordnung eines äusseren Ziels gesputtert sind.

13. Verfahren nach Anspruch 12, umfassend ein individuell abwechselndes Erzeugen des ersten und zweiten Magnetfeldes, um jeweils ein abwechselndes Sputtern von Material von der Anordnung (1a, 1b; 31a, 31b) eines inneren Ziels und der Anordnung (3a, 3b; 32a, 32b) eines äusseren Ziels zu erzielen, um die Mehrzahl von Sputterschichten bereitzustellen.

14. Verfahren nach Anspruch 12, umfassend:
- zunächst Erzeugen des ersten Magnetfeldes bei einem niedrigen Pegel, und ein gleichzeitiges Erzeugen des zweiten Magnetfeldes bei einem Pegel, welcher wirksam ist zum Sputtern von Material von der zweiten Ziel-Anordnung auf das Substrat;
- ein nachfolgendes Erzeugen des zweiten Magnetfeldes bei einem niedrigen Pegel, und ein gleichzeitiges Erzeugen des ersten Magnetfeldes bei einem Pegel, welcher wirksam ist zum Sputtern von Material von der inneren Ziel-Anordnung auf das Substrat;
wobei die Magnetfelder mit niedrigem Pegel dazu wirksam sind, Material-Querkontaminationen zwischen der jeweiligen Anordnung eines inneren Ziels und der Anordnung eines äusseren Ziels zu unterdrücken.

15. Verfahren zum Herstellen eines durch Sputtern beschichteten Substrats, umfassend ein Sputtern gemäss dem Verfahren nach einem der Ansprüche 7 bis 14.

## Revendications

1. Source de pulvérisation comprenant :
- un dispositif cible intérieur (1 a, 1b; 31a, 31b) et un dispositif cible extérieur (3a, 3b ; 32a, 32b), ledit dispositif cible extérieur (3a, 3b ; 32a, 32b) étant disposé autour dudit dispositif cible intérieur (1a, 1b ; 31a, 31b) vu de dessus, chacun desdits dispositifs cibles intérieur (1a, 1b ; 31a, 31b) et extérieur (3a, 3b ; 32a, 32b) comprenant un module supérieur respectif (1 a, 3a ; 31 a, 32a) et un module inférieur respectif (1 b, 3b ; 31 b, 32b), chacun desdits modules supérieurs respectifs (1 a, 3a; 31 a, 32a) étant disposé espacé de et de façon essentiellement parallèle au plan dudit module inférieur respectif (1 b, 3b; 31 b, 32b), chacun desdits modules supérieurs respectifs (1 a, 3a; 31 a, 32a) faisant saillie partiellement au-dessus dudit module inférieur respectif (1 b, 3b ; 31 b, 32b) ; et
- des moyens pour générer des champs magnétiques, lesdits moyens pour générer des champs magnétiques pouvant fonctionner pour générer séparément des premiers et des deuxièmes champs magnétiques contrôlables individuellement, respectivement, au moins partiellement au-dessus desdits dispositifs cibles intérieur (1a, 1b, 31a, 31b) et extérieur (3a, 3b ; 32a, 32b).

2. Source de pulvérisation selon la revendication 1, dans laquelle lesdits moyens pour générer un champ magnétique comprennent des sources d'énergie séparées allouées pour générer lesdits champs magnétiques contrôlables individuellement.

3. Source de pulvérisation selon l'une des revendications précédentes, comprenant en outre un dispositif cible médian (2) agencé entre ledit dispositif cible intérieur (1a, 1b) et ledit dispositif cible extérieur (3a, 3b), vu de dessus.

4. Source de pulvérisation selon l'une des revendications précédentes, dans laquelle lesdits moyens de génération de champs magnétiques peuvent être utilisés pour générer séparément un troisième champ magnétique contrôlable individuellement au moins partiellement au-dessus dudit dispositif cible médian.

5. Source de pulvérisation selon l'une des revendications précédentes, dans laquelle lesdits dispositifs cibles intérieur (1a, 1b ; 31a, 31b) et extérieur (3a, 3b ; 32a, 32b) comprennent chacun des modules supérieurs respectifs (1 a, 3a; 31 a, 32a) agencés sur un plan supérieur commun, lesdits modules inférieurs respectifs (1b, 3b; 31 b, 32b) étant agencés dans un plan inférieur commun, ledit plan supérieur étant espacé et agencé essentiellement parallèle audit plan inférieur.

6. Source de pulvérisation selon l'une des revendications précédentes, dans laquelle l'un desdits dispositifs cibles intérieur et extérieur comprend une matière à grand pouvoir de magnétisation par saturation et dans laquelle l'autre dispositif cible comprend une matière à faible magnétisation par saturation.

7. Procédé de pulvérisation consistant à :
- fournir une source de pulvérisation comprenant un dispositif cible intérieur (1 a, 1b ; 31a, 31b) et un dispositif cible extérieur (3a, 3b ; 32a, 32b), ledit dispositif cible extérieur (3a, 3b ; 32a, 32b) étant disposé autour dudit dispositif cible intérieur (1 a, 1 b ; 31 a, 31 b) vu de dessus, chacun desdits dispositifs cibles intérieur (1 a, 1 b ; 31a, 31 b) et extérieur (3a, 3b ; 32a, 32b) comprenant un module supérieur respectif (1a, 3a ; 31a, 32a) et un module inférieur respectif (1b, 3b ; 31 b, 32b), chacun desdits modules inférieurs respectifs (1a, 3a ; 31a, 32a) étant agencé dans un plan espacé de et essentiellement parallèle au plan dudit module inférieur respectif (1 b, 3b ; 31b, 32b), chacun desdits modules supérieurs respectifs (1 a, 3a; 31a, 32a) faisant partiellement saillie au-dessus dudit module inférieur respectif (1b, 3b, 31b, 32b) ;
- fournir un substrat disposé au-dessus et à distance desdits dispositifs cibles ;
- générer un premier champ magnétique au moins partiellement au-dessus dudit dispositif cible intérieur (1 a, 1b; 31a, 31b) pour ainsi pulvériser de la matière depuis ledit dispositif cible intérieur (1 a, 1 b ; 31a, 31 b) sur ledit substrat ; et
- générer un deuxième champ magnétique au moins partiellement au-dessus dudit dispositif cible extérieur (3a, 3b ; 32a, 32b) pour ainsi pulvériser de la matière depuis ledit dispositif cible extérieur (3a, 3b ; 32a, 32b) sur ledit substrat ;
dans lequel, ledit premier champ magnétique est généré et contrôlé indépendamment dudit deuxième champ magnétique.

8. Procédé selon la revendication 7, dans lequel chacun desdits premier et deuxième champs magnétiques est généré depuis sa propre source d'énergie.

9. Procédé selon la revendication 7 ou 8, dans lequel ladite source de pulvérisation comprend en outre un dispositif cible médian (2) agencé entre ledit dispositif cible intérieur (1a, 1b) et ledit dispositif cible extérieur (3a, 3b) vu de dessus, le procédé consistant en outre à générer un troisième champ magnétique au moins partiellement au-dessus dudit dispositif cible médian pour ainsi pulvériser de la matière depuis ledit dispositif cible médian sur ledit substrat, dans lequel ledit troisième champ magnétique est généré et contrôlé indépendamment de chacun desdits premier et deuxième champs magnétiques.

10. Procédé selon l'une des revendications 7 à 9, consistant à effectuer une copulvérisation de matière depuis chacun desdits dispositifs cibles intérieur (1a, 1b; 31a, 31b) et extérieur (3a, 3b; 32a, 32b) sur ledit substrat pour produire une couche d'alliage comprenant de la matière de chacun desdits dispositifs cibles.

11. Procédé selon la revendication 10, consistant à générer lesdits premier et deuxième champs magnétiques simultanément pour obtenir ladite copulvérisation.

12. Procédé selon l'une des revendications 7 à 9, consistant à pulvériser de la matière depuis l'un desdits dispositifs cibles intérieur (1 a, 1b ; 31 a, 31b) et extérieur (3a, 3b ; 32a, 32b) sur ledit substrat et à pulvériser ensuite de la matière depuis l'autre desdits dispositifs cibles intérieur (1a, 1b ; 31a, 31b) et extérieur (3a, 3b ; 32a, 32b) sur ledit substrat, fournissant ainsi une pluralité de couches pulvérisées sur ledit substrat comprenant des couches discrètes de matière pulvérisée alternativement depuis lesdits dispositifs cibles intérieur et extérieur.

13. Procédé selon la revendication 12, consistant en outre à générer alternativement lesdits premier et deuxième champs magnétiques individuellement pour obtenir une pulvérisation alternée de matière depuis lesdits dispositifs cibles intérieur (1a, 1b ; 31a, 31b) et extérieur (3a, 3b ; 32a, 32b), respectivement, pour fournir ladite pluralité de couches pulvérisées.

14. Procédé selon la revendication 12, consistant à :
- générer d'abord ledit premier champ magnétique à un faible niveau et à générer simultanément ledit deuxième champ magnétique à un niveau efficace pour pulvériser la matière depuis ledit deuxième dispositif cible sur ledit substrat :
- générer ensuite ledit deuxième champ magnétique à un faible niveau et à générer simultanément ledit premier champ magnétique à un niveau efficace pour pulvériser la matière depuis ledit dispositif cible intérieur sur ledit substrat ;
dans lequel, lesdits champs magnétiques à faible niveau sont efficaces pour empêcher la contamination croisée de la matière entre les dispositifs cibles intérieur et extérieur respectifs.

15. Procédé pour fabriquer un substrat recouvert par pulvérisation consistant à pulvériser conformément au procédé de l'une des revendications 7 à 14.
